(19) **Europäisches Patentamt / European Patent Office / Office européen des brevets**

(11) **EP 4 772 550 A1**

(12) **EUROPEAN PATENT APPLICATION**
published in accordance with Art. 153(4) EPC

(43) Date of publication:
**08.07.2026 Bulletin 2026/28**

(21) Application number: **24871839.7**

(22) Date of filing: **10.09.2024**

(51) International Patent Classification (IPC):
*C08F 220/06* $^{(2006.01)}$   *B24B 37/00* $^{(2012.01)}$
*C08L 33/02* $^{(2006.01)}$   *C09K 3/14* $^{(2006.01)}$
*H01L 21/304* $^{(2006.01)}$

(52) Cooperative Patent Classification (CPC):
**B24B 37/00; C08F 212/08; C08F 220/06;**
**C08K 3/22; C08L 25/08; C08L 33/02; C09G 1/02;**
**C09K 3/14; H10P 52/00**

(86) International application number:
**PCT/JP2024/032407**

(87) International publication number:
**WO 2025/070042 (03.04.2025 Gazette 2025/14)**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH MA MD TN**

(30) Priority: **29.09.2023 JP 2023169438**

(71) Applicant: **Resonac Corporation**
**Tokyo 105-7325 (JP)**

(72) Inventors:
• **ARAKI, Motoaki**
**Tokyo 105-7325 (JP)**
• **KUZUTANI, Takuya**
**Tokyo 105-7325 (JP)**
• **ICHIKAWA, Yuki**
**Tokyo 105-7325 (JP)**
• **TANAKA, Takaaki**
**Tokyo 105-7325 (JP)**
• **MATSUMOTO, Takaaki**
**Tokyo 105-7325 (JP)**

(74) Representative: **Hoffmann Eitle**
**Patent- und Rechtsanwälte PartmbB**
**Arabellastraße 30**
**81925 München (DE)**

(54) **POLYMER, POLYMER COMPOSITION, POLISHING LIQUID SET, POLISHING LIQUID, METHOD FOR PRODUCING POLISHING LIQUID, AND POLISHING METHOD**

(57)    A polymer for a polishing liquid, the polymer having a first structural unit derived from at least one styrenic compound selected from the group consisting of styrene and styrene derivatives and a second structural unit derived from at least one methacrylic acid compound selected from the group consisting of methacrylic acid and its salts, wherein a content of the first structural unit is more than 0 mol% and 38 mol% or less.

EP 4 772 550 A1

## Description

### Technical Field

The present disclosure relates to a polymer, a polymer composition, a polishing liquid set, a polishing liquid, a method for producing a polishing liquid, a polishing method, and the like.

### Background Art

In recent years, in manufacturing processes of semiconductor components, the importance of processing technologies for higher integration and finer feature sizes has increasingly grown. CMP (Chemical Mechanical Polishing) technology, which is one of such processing technologies, has become an indispensable technology in manufacturing processes of semiconductor components, for example, for forming STI, for planarizing pre-metal insulating films or interlayer insulating films, and for forming plugs or embedded metal wirings. As a polishing liquid used in a polishing step such as a CMP step, there is known a polishing liquid containing abrasive grains, a polymer, and an aqueous medium (see, for example, Patent Literatures 1 to 3 below).

### Citation List

### Patent Literature

[Patent Literature 1] PCT International Publication No. 2015/170436
[Patent Literature 2] Japanese Unexamined Patent Publication No. 2011-103498
[Patent Literature 3] PCT International Publication No. 2007/055278

### Summary of Invention

### Technical Problem

There are cases where components constituting a polishing liquid are stored in a state in which they are separated into a polymer composition (polymer-containing composition) containing a polymer for a polishing liquid and an aqueous medium and other components such as abrasive grains, and a polishing liquid is obtained by mixing the polymer composition and such other components. However, since there are cases where precipitates are generated when a certain time elapses after preparing the polymer composition containing the polymer for a polishing liquid and the aqueous medium, it is required to improve storage stability of the polymer composition.

Further, in recent semiconductor components, miniaturization has been increasingly accelerated, and film thickness has been reduced along with the reduction in wiring width. Accordingly, stricter standards are required in manufacturing processes of semiconductor components, and there has arisen a need to highly planarize a base substrate having a plurality of insulating members. For example, in CMP technology (such as CMP technology for forming STI), there are cases where a pattern wafer having a substrate with a pattern of protrusions and recesses, a stopper (a member containing a stopper material) disposed on protrusions of the substrate, and an insulating member (a member containing an insulating material) disposed on the substrate and the stopper so as to fill recesses of the substrate is polished. In such polishing, polishing of the insulating member is stopped by the stopper, and polishing of the insulating member is stopped at a stage where the stopper is exposed. This is because it is difficult to artificially control the polishing amount of the insulating member (for example, the removal thickness of the insulating member), and the degree of polishing is controlled by polishing the insulating member until the stopper is exposed.

In CMP technology, after polishing of the insulating member is stopped at a stage where the stopper is exposed, additional polishing is sometimes performed even after the stopper is exposed in order to avoid leaving the insulating member on the stopper. This additional polishing is referred to as "over-polishing". On the other hand, in a case where over-polishing is performed, there are cases where insulating members other than the insulating member remaining on the stopper (insulating members embedded in recesses of the substrate) are excessively polished. As a result, there are cases where dishing (a phenomenon in which insulating members other than the insulating member remaining on the stopper (insulating members embedded in recesses of the substrate) are excessively polished) proceeds, and flatness after polishing is degraded. Therefore, for a polishing liquid containing abrasive grains, it is required to suppress excessive dishing during over-polishing of a pattern wafer having protrusions and recesses.

One aspect of the present disclosure is to provide a polymer that can obtain a polymer composition having excellent storage stability as a polymer composition containing the polymer and an aqueous medium, and can obtain a polishing liquid capable of suppressing excessive dishing during over-polishing of a pattern wafer as a polishing liquid containing abrasive grains and the polymer. Another aspect of the present disclosure is to provide a polymer composition containing the polymer. Another aspect of the present disclosure is to provide a polishing liquid set having the polymer composition. Another aspect of the present disclosure is to provide a polishing liquid containing the polymer. Another aspect of the present disclosure is to provide a method for producing a polishing liquid using the polymer composition. Another aspect of the present disclosure is to provide a polishing method using the polishing liquid.

**Solution to Problem**

The present disclosure, in some aspects, relates to the following items [1] to [12] and the like.

[1] A polymer for a polishing liquid, the polymer having a first structural unit derived from at least one styrenic compound selected from the group consisting of styrene and styrene derivatives and a second structural unit derived from at least one methacrylic acid compound selected from the group consisting of methacrylic acid and its salts, wherein the content of the first structural unit is more than 0 mol% and 38 mol% or less.
[2] The polymer according to [1], wherein the first structural unit includes a structural unit derived from styrene.
[3] The polymer according to [1] or [2], wherein the content of the second structural unit is 60 to 90 mol%.
[4] The polymer according to any one of [1] to [3], wherein a converted total amount of carboxyl groups and carboxylate groups is $6.7 \times 10^{-3}$ mol/g or more, and the converted total amount is calculated by replacing carboxylate groups in the polymer with carboxyl groups.
[5] The polymer according to any one of [1] to [4], wherein a weight-average molecular weight is 3000 to 500000.
[6] A polymer composition containing the polymer according to any one of [1] to [5] and an aqueous medium.
[7] A polishing liquid set having the polymer composition according to [6] and a liquid containing abrasive grains and an aqueous medium.
[8] The polishing liquid set according to [7], wherein the abrasive grains contain at least one selected from the group consisting of cerium oxides, silicon oxides, aluminum oxides, zirconium oxides, and yttrium oxides.
[9] A polishing liquid containing abrasive grains, the polymer according to any one of [1] to [5], and an aqueous medium.
[10] The polishing liquid according to [9], wherein the abrasive grains contain at least one selected from the group consisting of cerium oxides, silicon oxides, aluminum oxides, zirconium oxides, and yttrium oxides.
[11] A method for producing a polishing liquid, including a step of mixing the polymer composition according to [6] and a liquid containing abrasive grains and an aqueous medium.
[12] A polishing method including a step of polishing a surface to be polished using the polishing liquid according to [9].

**Advantageous Effects of Invention**

According to one aspect of the present disclosure, it is possible to provide a polymer that can obtain a polymer composition having excellent storage stability as a polymer composition containing the polymer and an aqueous medium, and can obtain a polishing liquid capable of suppressing excessive dishing during over-polishing of a pattern wafer as a polishing liquid containing abrasive grains and the polymer. According to another aspect of the present disclosure, it is possible to provide a polymer composition containing the polymer. According to another aspect of the present disclosure, it is possible to provide a polishing liquid set having the polymer composition. According to another aspect of the present disclosure, it is possible to provide a polishing liquid containing the polymer. According to another aspect of the present disclosure, it is possible to provide a method for producing a polishing liquid using the polymer composition. According to another aspect of the present disclosure, it is possible to provide a polishing method using the polishing liquid.

**Description of Embodiments**

Hereinafter, embodiments of the present disclosure will be described in detail.

<Definitions>

In the present specification, the term "polishing liquid" is defined as a composition that comes into contact with a surface to be polished during polishing. The term "polishing liquid" itself does not limit components contained in the polishing liquid in any way. As described later, a polishing liquid of the present embodiment can contain abrasive grains. Abrasive grains are also referred to as "abrasive particles", but in the present specification, they are referred to as "abrasive grains". Abrasive grains are generally solid particles, and it is considered that an object to be removed is removed by mechanical action of the abrasive grains and chemical action of the abrasive grains (mainly surfaces of abrasive grains) during polishing, but a polishing mechanism is not limited.

In the present specification, the term "step" includes not only an independent step but also a step whose intended action is achieved even when the step cannot be clearly distinguished from another step. A numerical range indicated using "to" indicates a range including numerical values described before and after "to" as a minimum value and a maximum value, respectively. In numerical ranges described stepwise in the present specification, an upper limit value or a lower limit value of a numerical range at one stage can be arbitrarily combined with an upper limit value or a lower limit value of a numerical range at another stage. In numerical ranges described in the present specification, the upper limit value or the lower limit value of the numerical range may be replaced with a value shown in Examples. Unless otherwise specified, a material exemplified in the present specification may be used alone or in combination of two or more kinds. When a plurality of substances corresponding to each component are present in a composition, an amount of each component in the composition means, unless otherwise specified, a total amount of the plurality of substances present in the composition. The term "polishing rate" means a rate at which a material is removed per unit time (removal rate). The expression "A or B" means that either one of A and B may be included and both may be included. The expression "A or more" for a numerical range means A and a range exceeding A. The expression "A or less" for a numerical range means A and a range less than A. A "hydroxy group" does not include an OH structure contained in a carboxyl group or a sulfo group (sulfonic acid group). A "carboxylate group" has a structure in which a carboxyl group forms a salt, and examples thereof include -COONa, -COOK, and $-COONH_4$. A "main chain" in a polymer refers to a molecular chain constituting a longest molecular chain (for example, a hydrocarbon chain) in the polymer, and a "side chain" refers to a molecular chain other than the main chain. An "aqueous medium" is water, or a hydrophilic solvent that is miscible with water at 25°C.

In the present specification, unless otherwise specified, the term "ethylenically unsaturated bond" refers to an ethylenically unsaturated bond having radical polymerizability. In the case of a polymer having a structural unit A derived from a compound A having an ethylenically unsaturated bond A as an example, a chemical structure of a portion other than a portion corresponding to the ethylenically unsaturated bond A of the compound A in the structural unit A of the polymer is the same as a chemical structure of a portion other than the ethylenically unsaturated bond A in the compound A before polymerization. For example, a structural unit derived from styrene has a structure of "$-CH_2CH(C_6H_5$ (phenyl group))-" in a polymer. In a structural unit having an ionic functional group, even when ion exchange is performed after polymerization, the structural unit is referred to based on the structure of the polymer. For example, when the corresponding structural unit is modified to "$-CH_2CH(COOH)-$" by ion exchange after polymerization of sodium acrylate, this structural unit is referred to as a "structural unit derived from acrylic acid".

In the present specification, as a particle diameter of particles such as abrasive grains, a median diameter (D50) is a particle diameter at which the cumulative particle size distribution on a volume basis is 50%. The median diameter (D50) can be measured by using a dispersion liquid (for example, a polishing liquid) in which particles are dispersed in a liquid as a sample and using a laser diffraction/scattering type particle size distribution measuring apparatus (product name: Microtrac MT3300EXII, manufactured by MicrotracBEL Corp.).

In the present specification, a pH of a liquid (solution, dispersion, etc.) can be measured under the following conditions.

Measurement temperature: 25°C ± 0.5°C

Measuring apparatus: model D-71, manufactured by HORIBA, Ltd.

Measuring method: After performing two-point calibration using standard buffer solutions (phthalate pH buffer solution, pH: 4.01 (25°C); and neutral phosphate pH buffer solution, pH: 6.86 (25°C)), the electrode is placed in the liquid, and a pH after an elapse of 3 minutes or more and stabilization can be measured by the measuring apparatus described above.

<Polymer>

A polymer of the present embodiment is a polymer for a polishing liquid (a polymer used as a component constituting a polishing liquid), and may be, for example, a polymer for a CMP polishing liquid (a polymer used as a component constituting a CMP polishing liquid). The polymer of the present embodiment has a first structural unit (monomer unit of a styrenic compound) derived from at least one styrenic compound selected from the group consisting of styrene and styrene derivatives and a second structural unit (monomer unit of a methacrylic acid compound) derived from at least one methacrylic acid compound selected from the group consisting of methacrylic acid and its salts (salts of methacrylic acid). That is, the polymer of the present embodiment has a styrenic compound and a methacrylic acid compound as monomer units. A content of the first structural unit in the polymer of the present embodiment is more than 0 mol% and 38 mol% or less. Hereinafter, the polymer of the present embodiment will be referred to as "polymer P" in some cases.

According to polymer P of the present embodiment, in a polymer composition (polymer-containing composition) containing polymer P and an aqueous medium, it is possible to suppress generation of precipitates over time and to obtain a polymer composition having excellent storage stability. For example, according to polymer P of the present embodiment, as shown in an evaluation method (visual observation of presence or absence of precipitates) described in Examples below, when a polymer composition held at 60°C for 7 days (168 hours) after preparation is centrifuged, an evaluation result of A, B, or C can be obtained.

There are cases where a pH of a polishing liquid is adjusted depending on a type of an object to be polished and the like, and may be adjusted, for example, to an acidic region. Therefore, when components constituting a polishing liquid are stored in a state where they are separated into a polymer composition containing a polymer for a polishing liquid and other components such as abrasive grains, there are cases where the pH of the polymer composition is also adjusted to an acidic region such that a pH of the polishing liquid is adjusted to an acidic region when the polymer composition and the other components are mixed. However, when a pH of a polymer composition containing a polymer for a polishing liquid is maintained in an acidic region, there are cases where precipitates are generated, and therefore, it is required to improve storage stability of a polymer composition having a pH in an acidic region. In contrast, according to one embodiment of polymer P of the present embodiment, even when a polymer composition containing polymer P and an aqueous medium has a pH in an acidic region (for example, a pH of 4.0 or more and less than 7.0), it is possible to suppress generation of precipitates over time and to obtain a polymer composition having excellent storage stability. It is sufficient that one embodiment of polymer P of the present embodiment has a property of suppressing generation of precipitates over time when the polymer composition has a pH in an acidic region, and it may be used in a polymer composition not having a pH in an acidic region.

There are cases where the transmittance of a polymer composition containing a polymer for a polishing liquid and an aqueous medium decreases over time after preparation. In contrast, according to one embodiment of polymer P of the present embodiment, in a polymer composition containing polymer P and an aqueous medium, it is possible to suppress a decrease in transmittance over time and to obtain a polymer composition having further excellent storage stability. Further, according to one embodiment of polymer P of the present embodiment, even when a polymer composition containing polymer P and an aqueous medium has a pH in an acidic region, it is possible to suppress a decrease in transmittance over time. For example, according to one embodiment of polymer P of the present embodiment, as shown in an evaluation method (measurement of transmittance) described in Examples below, in a supernatant liquid obtained by centrifuging a polymer composition held at 60°C for 7 days (168 hours) after preparation, it is possible to obtain, for example, 90% or more (preferably 94% or more, 96% or more, 97% or more, etc.) as a transmittance of light having a wavelength of 700 nm.

According to polymer P of the present embodiment, it is possible to obtain, as a polishing liquid containing abrasive grains and polymer P, a polishing liquid capable of suppressing excessive dishing during over-polishing of a pattern wafer. Accordingly, it is possible to polish a surface of a pattern wafer and planarize the surface with high accuracy. For example, according to polymer P of the present embodiment, by using a polishing liquid containing abrasive grains and polymer P, it is possible to suppress excessive dishing during over-polishing of a portion of L/S = 20/80 $\mu$m (a pattern in which protrusions having a width of 20 $\mu$m and recesses having a width of 80 $\mu$m are alternately arranged) in a pattern wafer, and as shown in an evaluation method described in Examples below, it is possible to reduce a remaining step amount of the portion of L/S = 20/80 $\mu$m to, for example, 60 nm or less (preferably 50 nm or less, 40 nm or less, 30 nm or less, 20 nm or less, etc.).

According to one embodiment of polymer P of the present embodiment, by using a polishing liquid containing abrasive grains and polymer P, it is possible to suppress excessive dishing during over-polishing of a portion of L/S = 50/50 $\mu$m (a pattern in which protrusions having a width of 50 $\mu$m and recesses having a width of 50 $\mu$m are alternately arranged) in a pattern wafer, and as shown in an evaluation method described in Examples below, it is possible to reduce a remaining step amount of the portion of L/S = 50/50 $\mu$m to, for example, 30 nm or less (preferably 20 nm or less, 10 nm or less, 5.0 nm or less, etc.).

According to one embodiment of polymer P of the present embodiment, it is possible to obtain a polishing liquid capable of suppressing excessive polishing of a stopper disposed on protrusions during over-polishing of a pattern wafer. According to one embodiment of polymer P of the present embodiment, by using a polishing liquid containing abrasive grains and polymer P, it is possible to suppress excessive polishing of the stopper during over-polishing of a portion of L/S = 20/80 $\mu$m in a pattern wafer, and as shown in an evaluation method described in Examples below, it is possible to reduce a stopper polishing amount for the portion of L/S = 20/80 $\mu$m to, for example, 4.0 nm or less (preferably 2.0 nm or less, 1.5 nm or less, etc.). According to one embodiment of polymer P of the present embodiment, by using a polishing liquid containing abrasive grains and polymer P, it is possible to suppress excessive polishing of the stopper during over-polishing of a portion of L/S = 50/50 $\mu$m in a pattern wafer, and as shown in an evaluation method described in Examples below, it is possible to reduce a stopper polishing amount for the portion of L/S = 50/50 $\mu$m to, for example, 1.0 nm or less (preferably 0.5 nm or less, 0.3 nm or less, etc.).

According to one embodiment of polymer P of the present embodiment, by using a polishing liquid containing abrasive grains and polymer P, in a case where a pattern wafer has a substrate having a protrusions and recesses, a stopper (a member containing a stopper material) disposed on protrusions of the substrate, and an insulating member (a member containing an insulating material) disposed on the substrate and the stopper so as to fill recesses of the substrate, and a stopper material is silicon nitride and an insulating material is silicon oxide, it is possible to suppress excessive dishing during over-polishing and to suppress over-polishing of the stopper during over-polishing.

Polymer P of the present embodiment has a first structural unit derived from at least one styrenic compound selected from the group consisting of styrene and styrene derivatives. The first structural unit may include a structural unit derived from styrene from the viewpoint of easily suppressing excessive dishing (easily suppressing excessive dishing during over-polishing of a pattern wafer (unless otherwise specified, any pattern portion such as a portion of L/S = 20/80 $\mu$m or a portion of L/S = 50/50 $\mu$m) using a polishing liquid containing abrasive grains and polymer P; the same applies hereinafter) or the viewpoint of easily suppressing excessive polishing of a stopper (easily suppressing excessive polishing of the stopper during over-polishing of a pattern wafer (unless otherwise specified, any pattern portion such as a portion of L/S = 20/80 $\mu$m or a portion of L/S = 50/50 $\mu$m) using a polishing liquid containing abrasive grains and polymer P; the same applies hereinafter).

A solubility of a styrenic compound in water at 25°C may be within the following range. The solubility of the styrenic compound may be 0.1 g/100 mL or less, 0.05 g/100 mL or less, or 0.03 g/100 mL or less from the viewpoint of easily suppressing excessive dishing or the viewpoint of easily suppressing excessive polishing of a stopper. The solubility of the styrenic compound may be 0.01 g/100 mL or more, 0.02 g/100 mL or more, or 0.025 g/100 mL or more from the viewpoint of easily obtaining excellent storage stability of a polymer composition. From these viewpoints, the solubility of the styrenic compound may be 0.01 to 0.1 g/100 mL. The solubility of styrene in water at 25°C is 0.03 g/100 mL.

Examples of the styrene derivative include alkylstyrenes ($\alpha$-methylstyrene and the like), alkoxystyrenes ($\alpha$-methoxystyrene, p-methoxystyrene, and the like), m-chlorostyrene, trimethylsilylstyrene, 4-carboxystyrene, and styrenesulfonic acid. The styrene derivative may include at least one selected from the group consisting of hydrocarbon compounds and compounds in which at least one hydrogen atom in the hydrocarbon compounds is substituted with a halogen atom, and may include hydrocarbon compounds from the viewpoint of easily suppressing excessive dishing or the viewpoint of easily suppressing excessive polishing of a stopper. The first structural unit in polymer P may have an embodiment composed of structural units derived from at least one selected from the group consisting of hydrocarbon compounds and compounds in which at least one hydrogen atom in the hydrocarbon compounds is substituted with a halogen atom, and may have an embodiment composed of structural units derived from hydrocarbon compounds.

The styrene derivative may not have a structure having hydrophilicity from the viewpoint of easily suppressing excessive dishing or the viewpoint of easily suppressing excessive polishing of a stopper. Examples of the structure having hydrophilicity include polyether groups, hydroxy groups, carboxyl groups, carboxylate groups, sulfonic acid groups, and amino groups.

A content (content rate) of the first structural unit in polymer P is 38 mol% or less based on a total amount of structural units constituting polymer P from the viewpoint of obtaining excellent storage stability of a polymer composition. The content of the first structural unit may be 35 mol% or less, 32 mol% or less, 30 mol% or less, 28 mol% or less, 25 mol% or less, 22 mol% or less, 20 mol% or less, 18.5 mol% or less, 18 mol% or less, or 17 mol% or less, from the viewpoint of easily obtaining excellent storage stability of a polymer composition, the viewpoint of easily suppressing excessive dishing, or the viewpoint of easily suppressing excessive polishing of a stopper. The content of the first structural unit may be 16 mol% or less, 15.5 mol% or less, 15 mol% or less, less than 15 mol%, 14.5 mol% or less, or 14 mol% or less. A content (content rate) of the first structural unit in polymer P is more than 0 mol% based on a total amount of structural units constituting polymer P from the viewpoint of suppressing excessive dishing during over-polishing of a portion of L/S = 20/80 $\mu$m in a pattern wafer or the viewpoint of easily suppressing excessive polishing of a stopper. The content of the first structural unit may be 1.0 mol% or more, 3.0 mol% or more, 5.0 mol% or more, 7.0 mol% or more, 9.0 mol% or more, 10 mol% or more, 11 mol% or more, 13 mol% or more, 14 mol% or more, 14.5 mol% or more, 15 mol% or more, 15.5 mol% or more, 16 mol% or more, or 17 mol% or more, from the viewpoint of easily obtaining excellent storage stability of a polymer composition, the viewpoint of easily suppressing excessive dishing, or the viewpoint of easily suppressing excessive polishing of a stopper. The content of the first structural unit may be 18 mol% or more, 18.5 mol% or more, 20 mol% or more, 22 mol% or more, 25 mol% or more, 28 mol% or more, or 30 mol% or more. From these viewpoints, the content of the first structural unit in polymer P may be more than 0 mol% and 35 mol% or less, 1.0 to 38 mol%, 5.0 to 38 mol%, 7.0 to 35 mol%, 9.0 to 32 mol%, 11 to 25 mol%, 13 to 25 mol%, or 15.5 to 18.5 mol%. In a case where polymer P has a structural unit derived from styrene and a structural unit derived from a styrene derivative, the content of the first structural unit is a total amount of the structural unit derived from styrene and the structural unit derived from the styrene derivative.

Polymer P of the present embodiment has a second structural unit derived from at least one methacrylic acid compound selected from the group consisting of methacrylic acid and its salts. Examples of the salt of methacrylic acid include alkali metal salts (sodium salt, potassium salt, and the like) and ammonium salts. The second structural unit may include a structural unit derived from methacrylic acid from the viewpoint of easily obtaining excellent storage stability of a polymer composition, the viewpoint of easily suppressing excessive dishing, or the viewpoint of easily suppressing excessive polishing of a stopper.

A content (content rate) of the second structural unit in polymer P may be less than 100 mol%, 99 mol% or less, 97 mol% or less, 95 mol% or less, 93 mol% or less, 91 mol% or less, 90 mol% or less, 89 mol% or less, 87 mol% or less, 86 mol% or less, 85.5 mol% or less, 85 mol% or less, 84.5 mol% or less, 84 mol% or less, or 83 mol% or less based on a total amount of structural units constituting polymer P, from the viewpoint of easily obtaining excellent storage stability of a polymer composition, the viewpoint of easily suppressing excessive dishing, or the viewpoint of easily suppressing excessive polishing of a stopper. The content of the second structural unit may be 82 mol% or less, 81.5 mol% or less, 80 mol% or less, 78 mol% or less, 75 mol% or less, 72 mol% or less, 70 mol% or less, 68 mol% or less, 65 mol% or less, 62 mol% or less, 60 mol% or less, 50 mol% or less, 40 mol% or less, 30 mol% or less, 20 mol% or less, 15 mol% or less, 12 mol% or less, or 10 mol% or less. A content (content rate) of the second structural unit in polymer P is more than 0 mol% from the viewpoint of obtaining excellent storage stability of a polymer composition and the viewpoint of suppressing excessive dishing during over-polishing of a portion of L/S = 20/80 μm in a pattern wafer. The content of the second structural unit may be 1.0 mol% or more, 3.0 mol% or more, 5.0 mol% or more, 7.0 mol% or more, 9.0 mol% or more, 10 mol% or more, 20 mol% or more, 30 mol% or more, 40 mol% or more, 50 mol% or more, 60 mol% or more, 62 mol% or more, 65 mol% or more, 68 mol% or more, 70 mol% or more, 72 mol% or more, 75 mol% or more, 78 mol% or more, 80 mol% or more, 81.5 mol% or more, 82 mol% or more, or 83 mol% or more, from the viewpoint of easily obtaining excellent storage stability of a polymer composition, the viewpoint of easily suppressing excessive dishing, or the viewpoint of easily suppressing excessive polishing of a stopper. The content of the second structural unit may be 84 mol% or more, 84.5 mol% or more, 85 mol% or more, 85.5 mol% or more, or 86 mol% or more. From these viewpoints, the content of the second structural unit in polymer P may be more than 0 mol% and less than 100 mol%, 65 mol% or more and less than 100 mol%, 62 to 99 mol%, 5.0 to 95 mol%, 7.0 to 95 mol%, 9.0 to 95 mol%, 50 to 93 mol%, 60 to 90 mol%, 65 to 91 mol%, 68 to 89 mol%, 75 to 87 mol%, or 81.5 to 85.5 mol%. In a case where polymer P has a structural unit derived from methacrylic acid and a structural unit derived from a salt of methacrylic acid, the content of the second structural unit is a total amount of the structural unit derived from methacrylic acid and the structural unit derived from the salt of methacrylic acid.

At least one selected from the group consisting of the first structural unit and the second structural unit may be contained in a main chain of polymer P and may be contained in a side chain of polymer P. The main chain in polymer P may have at least one selected from the group consisting of the first structural unit and the second structural unit and may have the first structural unit and the second structural unit, from the viewpoint of easily obtaining excellent storage stability of a polymer composition, the viewpoint of easily suppressing excessive dishing, or the viewpoint of easily suppressing excessive polishing of a stopper.

A total amount of the first structural unit and the second structural unit may be 10 mass% or more, 20 mass% or more, 30 mass% or more, 40 mass% or more, 50 mass% or more, 60 mass% or more, 70 mass% or more, 80 mass% or more, 90 mass% or more, 95 mass% or more, 97 mass% or more, 98 mass% or more, or 99 mass% or more based on a total mass of structural units constituting polymer P, from the viewpoint of easily obtaining excellent storage stability of a polymer composition, the viewpoint of easily suppressing excessive dishing, or the viewpoint of easily suppressing excessive polishing of a stopper. Structural units constituting polymer P may have an embodiment substantially composed of the first structural unit and the second structural unit (an embodiment in which substantially 100 mass% of the structural units constituting polymer P are the first structural unit and the second structural unit).

A molar ratio A of the content of the second structural unit with respect to the content of the first structural unit (amount-of-substance ratio: content of the second structural unit/content of the first structural unit) may be within the following range. The molar ratio A may be 0.10 or more, 0.30 or more, 0.50 or more, 0.80 or more, 1.0 or more, 2.0 or more, 2.5 or more, 3.0 or more, 3.5 or more, 4.0 or more, or 4.5 or more, from the viewpoint of easily obtaining excellent storage stability of a polymer composition, the viewpoint of easily suppressing excessive dishing, or the viewpoint of easily suppressing excessive polishing of a stopper. The molar ratio A may be 5.0 or more, 5.5 or more, or 6.0 or more. The molar ratio A may be 10 or less, 9.0 or less, 8.0 or less, 7.0 or less, 6.5 or less, 6.0 or less, 5.5 or less, or 5.0 or less, from the viewpoint of easily obtaining excellent storage stability of a polymer composition, the viewpoint of easily suppressing excessive dishing, or the viewpoint of easily suppressing excessive polishing of a stopper. The molar ratio A may be 4.5 or less, 4.0 or less, 3.5 or less, 3.0 or less, 2.5 or less, 2.0 or less, 1.0 or less, 0.80 or less, 0.50 or less, or 0.40 or less. From these viewpoints, the molar ratio A may be 0.10 to 10, 2.0 to 10, 4.5 to 10, 0.10 to 6.5, 2.0 to 6.5, 4.5 to 6.5, 0.10 to 5.5, 2.0 to 5.5, or 4.5 to 5.5.

Polymer P may have a structural unit derived from another monomer (a monomer not corresponding to the styrenic compound and the methacrylic acid compound) that can be polymerized with the styrenic compound or the methacrylic acid compound. As such monomer, a polymerizable vinyl compound can be used, and examples include acrylic acid; (meth)acrylic acid alkyl esters (methyl (meth)acrylate, ethyl (meth)acrylate, n-butyl (meth)acrylate, iso-butyl (meth)acrylate, tert-butyl (meth)acrylate, cyclohexyl (meth)acrylate, 2-ethylhexyl (meth)acrylate, lauryl (meth)acrylate, stearyl (meth)acrylate, isobornyl (meth)acrylate, and the like); heterocyclic vinyl compounds (vinylpyrrolidone and the like); hydroxyalkyl (meth)acrylates (2-hydroxyethyl (meth)acrylate, 2-hydroxypropyl (meth)acrylate, and the like); polyalkylene glycol (meth)acrylates (ethylene glycol (meth)acrylate, butylene glycol (meth)acrylate, and the like); alkylamino (meth)acrylates (N,N-dimethylaminoethyl (meth)acrylate, N,N-dimethylaminopropyl (meth)acrylate, and the like); vinyl ester compounds (vinyl formate, vinyl acetate, vinyl propionate, versatic acid vinyl (for example, product name: VeoVa 10, manufactured by Hexion Specialty Chemicals Inc.), and the like); monoolefin compounds (ethylene, propylene, butylene, isobutylene, and the like); conjugated diolefin compounds (butadiene, isoprene, chloroprene, and the like); $\alpha,\beta$-unsaturated mono- or dicarboxylic acids other than acrylic acid and methacrylic acid (crotonic acid, citraconic acid, maleic acid, itaconic acid, maleic anhydride, fumaric acid, and the like); carboxyl group-containing vinyl compounds (phthalic acid monohydroxyethyl (meth)acrylate, oxalic acid monohydroxypropyl (meth)acrylate, and the like); amine imide group-containing vinyl compounds (1,1,1-trimethylamine methacrylimide and the like); cyano group-containing vinyl compounds (acrylonitrile, methacrylonitrile, and the like); $\alpha,\beta$-ethylenically unsaturated compounds having an amide group or a substituted amide group ((meth)acrylamide, N-methylacrylamide, N,N-dimethyl (meth)acrylamide, N,N-dimethylaminopropyl (meth)acrylamide, and the like); $\alpha,\beta$-ethylenically unsaturated compounds having a carbonyl group (acrolein, diacetoneacrylamide, vinyl methyl ketone, diacetone acrylate, acetonitrile acrylate, and the like); and $\alpha,\beta$-ethylenically unsaturated compounds having a sulfonic acid group (allyl sulfonic acid, sodium p-styrenesulfonate, and the like).

Polymer P of the present embodiment may have a third structural unit derived from at least one selected from the group consisting of carboxylic acids other than methacrylic acid and salts thereof. Examples of the carboxylic acid other than methacrylic acid include acrylic acid, maleic acid, itaconic acid, and other carboxylic acids having an ethylenically unsaturated bond. In polymer P having the third structural unit, a content of the second structural unit is more than 0 mol% based on a total mass of structural units constituting polymer P from the viewpoint of obtaining excellent storage stability of a polymer composition and the viewpoint of suppressing excessive dishing during over-polishing of a portion of L/S = 20/80 $\mu$m in a pattern wafer using a polishing liquid containing abrasive grains and polymer P, and may be 1.0 mol% or more, 3.0 mol% or more, 5.0 mol% or more, 7.0 mol% or more, 9.0 mol% or more, or 10 mol% or more, from the viewpoint of easily obtaining excellent storage stability of a polymer composition, the viewpoint of easily suppressing excessive dishing, or the viewpoint of easily suppressing excessive polishing of a stopper. In polymer P having the third structural unit, the content of the second structural unit may be within each of the above ranges based on a total mass of structural units constituting polymer P, and may be, for example, 30 mol% or less, 20 mol% or less, 15 mol% or less, 12 mol% or less, or 10 mol% or less. In polymer P having the third structural unit, the content of the first structural unit may be within each of the above ranges.

In polymer P of the present embodiment, a content B of structural units derived from at least one selected from the group consisting of acrylic acid and maleic acid (a total amount of structural units derived from acrylic acid and structural units derived from maleic acid) may be within the following range based on a total mass of structural units constituting polymer P. The content B may be 70 mol% or less, 60 mol% or less, 50 mol% or less, 40 mol% or less, less than 40 mol%, 30 mol% or less, 20 mol% or less, 10 mol% or less, 5 mol% or less, or 1 mol% or less. The content B may be 0 mol% or more or more than 0 mol%.

In polymer P of the present embodiment, a content of structural units derived from monomers having at least one selected from the group consisting of sulfonic acid groups and sulfonate groups may be 5 mol% or less, less than 5 mol%, 1 mol% or less, or 0 mol% or less, and may be 0 mol%.

In polymer P of the present embodiment, a content of structural units derived from acrylonitrile may be 10 mol% or less, less than 10 mol%, 5 mol% or less, 1 mol% or less, or 0 mol% or less, and may be 0 mol%.

The content of structural units constituting polymer P can be measured by $^{13}$C-NMR. Specifically, the content of structural units constituting polymer P can be measured by $^{13}$C-NMR (resonance frequency: 100 MHz, measurement temperature: 25°C, relaxation delay: 4 seconds) using Avance NEO400 Onebay, manufactured by Bruker, equipped with CryoProbe™ 5 mm (BBO type), manufactured by Bruker, after dissolving polymer P and chromium (III) acetylacetonate in dimethyl sulfoxide-d6. The content of the structural units can be adjusted by adjusting the amount of each monomer used in synthesis of polymer P, the timing of charging, and the like.

A converted total amount C of carboxyl groups and carboxylate groups in polymer P of the present embodiment may be within the following range based on a total amount of polymer P. The converted total amount C may be $6.5\times10^{-3}$ mol/g or more, $6.7\times10^{-3}$ mol/g or more, $7.0\times10^{-3}$ mol/g or more, $7.4\times10^{-3}$ mol/g or more, $7.5\times10^{-3}$ mol/g or more, $8.0\times10^{-3}$ mol/g or more, $8.3\times10^{-3}$ mol/g or more, $8.5\times10^{-3}$ mol/g or more, $9.0\times10^{-3}$ mol/g or more, $9.1\times10^{-3}$ mol/g or more, or $9.3\times10^{-3}$ mol/g or more, from the viewpoint of easily obtaining favorable solubility of polymer P in an aqueous medium, the viewpoint of easily obtaining excellent storage stability of a polymer composition, the viewpoint of easily suppressing excessive dishing, or the viewpoint of easily suppressing excessive polishing of a stopper. The converted total amount C may be $9.5\times10^{-3}$ mol/g or more. The converted total amount C may be $1.1\times10^{-2}$ mol/g or less, $1.0\times10^{-2}$ mol/g or less, $9.8\times10^{-3}$ mol/g or less, $9.5\times10^{-3}$ mol/g or less, or $9.3\times10^{-3}$ mol/g or less, from the viewpoint of easily adjusting a pH of a polymer composition or a polishing liquid, the viewpoint of easily obtaining excellent storage stability of a polymer composition, the viewpoint of easily suppressing excessive dishing, or the viewpoint of easily suppressing excessive polishing of a stopper. The converted total amount C may be $9.1\times10^{-3}$ mol/g or less, $9.0\times10^{-3}$ mol/g or less, $8.5\times10^{-3}$ mol/g or less, $8.3\times10^{-3}$ mol/g or less, or $8.0\times10^{-3}$ mol/g or less. From these viewpoints, the converted total amount C may be $6.5\times10^{-3}$ to $1.1\times10^{-2}$ mol/g, $6.5\times10^{-3}$ to $9.8\times10^{-3}$ mol/g, $6.5\times10^{-3}$ to $9.5\times10^{-3}$ mol/g, $7.5\times10^{-3}$ to $1.1\times10^{-2}$ mol/g, $7.5\times10^{-3}$ to $9.8\times10^{-3}$ mol/g, $7.5\times10^{-3}$ to $9.5\times10^{-3}$ mol/g, $9.0\times10^{-3}$ to $1.1\times10^{-2}$ mol/g, $9.0\times10^{-3}$ to

$9.8 \times 10^{-3}$ mol/g, or $9.0 \times 10^{-3}$ to $9.5 \times 10^{-3}$ mol/g. The converted total amount C of carboxyl groups and carboxylate groups is calculated by replacing carboxylate groups in the polymer with carboxyl groups, and specifically can be calculated by a method described in Examples.

A weight-average molecular weight of polymer P may be within the following range from the viewpoint of easily obtaining excellent storage stability of a polymer composition, the viewpoint of easily suppressing excessive dishing, or the viewpoint of easily suppressing excessive polishing of a stopper. The weight-average molecular weight may be 500000 or less, 300000 or less, 200000 or less, 100000 or less, 80000 or less, 60000 or less, 50000 or less, 45000 or less, 43000 or less, 42000 or less, 40000 or less, or 39000 or less. The weight-average molecular weight may be 3000 or more, 5000 or more, 10000 or more, 20000 or more, more than 20000, 30000 or more, 35000 or more, 39000 or more, 40000 or more, 42000 or more, or 43000 or more. From these viewpoints, the weight-average molecular weight of polymer P may be 3000 to 500000, 3000 to 100000, 3000 to 50000, 30000 to 500000, 30000 to 100000, 30000 to 50000, 40000 to 500000, 40000 to 100000, or 40000 to 50000. The weight-average molecular weight (Mw) is a pullulan-equivalent value measured by gel permeation chromatography (GPC), and specifically can be measured by the method described in Examples.

<Polymer Composition>

A polymer composition (polymer-containing composition) of the present embodiment contains polymer P and an aqueous medium. In the polymer composition of the present embodiment, polymer P may be used alone as a single kind, or two or more kinds may be used in combination. For example, as two or more kinds of polymer P, polymers P having different contents of structural units (the first structural unit, the second structural unit, etc.) may be used, and polymers P having different types of structural units (the first structural unit, the second structural unit, etc.) may be used. The polymer composition of the present embodiment may not contain abrasive grains.

At least a part (a part or all) of polymer P in the polymer composition may be dissolved in the aqueous medium. A rate of polymer P dissolved in the aqueous medium in the polymer composition is not particularly limited, but may be 90 mass% or more, 95 mass% or more, or 99 mass% or more.

A content of polymer P in the polymer composition may be within the following range based on a total mass of the polymer composition. The content of polymer P may be 0.010 mass% or more, 0.050 mass% or more, 0.10 mass% or more, 0.50 mass% or more, 1.0 mass% or more, 2.0 mass% or more, or 3.0 mass% or more, from the viewpoint of easily suppressing excessive dishing or the viewpoint of easily suppressing excessive polishing of a stopper. The content of polymer P may be 30 mass% or less, 20 mass% or less, 10 mass% or less, 5.0 mass% or less, 4.0 mass% or less, or 3.0 mass% or less, from the viewpoint of easily enhancing storage stability by suppressing precipitation of polymer P. From these viewpoints, the content of polymer P may be 0.010 to 30 mass%, 0.10 to 20 mass%, 1.0 to 10 mass%, or 2.0 to 5.0 mass%.

The aqueous medium may include water and may include a hydrophilic solvent that is miscible with water at 25°C. Examples of the hydrophilic solvent include, but are not limited to, alcohols such as methanol and ethanol; and organic solvents such as acetone and N-methylpyrrolidone. A content of water in the aqueous medium is not particularly limited, but may be 50 mass% or more, 70 mass% or more, 85 mass% or more, or 95 mass% or more, and may be 100 mass%.

The polymer composition of the present embodiment may contain components other than abrasive grains, polymer P, and the aqueous medium. Examples of such components include water-soluble polymers other than polymer P, pH adjusters, buffers (buffers for stabilizing pH), and defoamers (for example, a silicone mixture).

The water-soluble polymer is defined as a polymer that dissolves in water in an amount of 0.1 g or more per 100 g of water (25°C). Examples of the water-soluble polymer other than polymer P include polyglycerin; polysaccharides such as alginic acid, pectic acid, carboxymethyl cellulose, agar, curdlan, and pullulan; homopolymers of unsaturated carboxylic acids such as acrylic acid, methacrylic acid, maleic acid, fumaric acid, and itaconic acid (polyacrylic acid and the like); ammonium salts or amine salts of the homopolymers; copolymers of unsaturated carboxylic acids such as acrylic acid, methacrylic acid, maleic acid, fumaric acid, and itaconic acid with monomers such as alkyl acrylates (methyl acrylate, ethyl acrylate, etc.), hydroxyalkyl acrylates (hydroxyethyl acrylate, etc.), alkyl methacrylates (methyl methacrylate, ethyl methacrylate, etc.), hydroxyalkyl methacrylates (hydroxyethyl methacrylate, etc.), vinyl acetate, and vinyl alcohol (copolymers of acrylic acid and alkyl acrylates, etc.); and ammonium salts or amine salts of the copolymers.

Examples of the pH adjuster include organic acids, inorganic acids, organic bases, and inorganic bases. Examples of the organic acid include formic acid, acetic acid, propionic acid, butyric acid, valeric acid, caproic acid, lactic acid, maleic acid, phthalic acid, citric acid, and succinic acid. Examples of the inorganic acid include nitric acid, sulfuric acid, hydrochloric acid, phosphoric acid, and boric acid. Examples of the organic base include triethylamine, pyridine, piperidine, pyrrolidine, imidazole, 2-methylimidazole, and chitosan. Examples of the inorganic base include tetramethylammonium hydroxide (TMAH), ammonia, potassium hydroxide, and sodium hydroxide.

The buffer may be supplied as a buffer solution (liquid containing a buffer). Examples of the buffer solution include acetate buffer and phthalate buffer.

A pH of the polymer composition of the present embodiment may be 4.0 or more, 4.5 or more, or 5.0 or more, from the viewpoint of easily obtaining favorable solubility of polymer P in the polymer composition. A pH of the polymer composition of the present embodiment may be less than 7.0, 6.5 or less, 6.0 or less, or 5.5 or less. From these viewpoints, a pH of the polymer composition of the present embodiment may be 4.0 or more and less than 7.0, 4.0 to 6.0, or 5.0 to 6.0.

<Polishing Liquid Set>

A polishing liquid set of the present embodiment has the polymer composition of the present embodiment and an abrasive grain-containing liquid (liquid containing abrasive grains and an aqueous medium) containing abrasive grains and an aqueous medium. A polishing liquid can be obtained by mixing the polymer composition and the abrasive grain-containing liquid of the polishing liquid set of the present embodiment. The polishing liquid set of the present embodiment may have the polymer composition, the abrasive grain-containing liquid, and a liquid containing components other than abrasive grains, polymer P, and an aqueous medium (water-soluble polymers, pH adjusters, buffers, defoamers, etc.). At least one selected from the group consisting of the polymer composition and the abrasive grain-containing liquid may contain the above components other than abrasive grains, polymer P, and an aqueous medium (water-soluble polymers, pH adjusters, buffers, defoamers, etc.).

From the viewpoint of easily obtaining a desired polishing rate of an insulating material (such as silicon oxide), the abrasive grains may contain at least one selected from the group consisting of cerium oxides, silicon oxides (for example, silica), aluminum oxides (for example, alumina), zirconium oxides (for example, zirconia), and yttrium oxides (for example, yttria), and may contain a cerium oxide. The cerium oxide may be $CeO_2$ (cerium oxide (IV), ceria) and may be $Ce_2O_3$ (cerium oxide (III)).

The abrasive grain-containing liquid may be an abrasive grain dispersion in which abrasive grains are dispersed in an aqueous medium. The abrasive grain dispersion may contain a dispersant (dispersant for abrasive grains) such as a phosphate compound or a hydrogen phosphate compound. As the aqueous medium of the abrasive grain dispersion, the aqueous medium described above for the polymer composition can be used. The aqueous medium of the polymer composition and the aqueous medium of the abrasive grain dispersion may have the same composition and may have different compositions.

<Polishing Liquid and Method for Producing the Same>

A polishing liquid of the present embodiment contains abrasive grains, polymer P, and an aqueous medium. In the polishing liquid of the present embodiment, the abrasive grains can be dispersed in the aqueous medium. At least a part (a part or all) of polymer P in the polishing liquid may dissolve in the aqueous medium. A rate of polymer P dissolved in the aqueous medium in the polishing liquid is not particularly limited, but may be 90 mass% or more, 95 mass% or more, or 99 mass% or more.

The polishing liquid of the present embodiment can be used as a CMP polishing liquid. The polishing liquid of the present embodiment can be used for polishing a surface to be polished that contains an insulating material. The polishing liquid of the present embodiment can be used for polishing a surface to be polished that contains an insulating material and a stopper material, and can be used for selectively polishing the insulating material with respect to the stopper material. According to the polishing liquid of the present embodiment, the surface to be polished can be suitably polished in a case where the insulating material includes silicon oxide and the stopper material includes silicon nitride.

The polishing liquid of the present embodiment may be obtained by mixing abrasive grains, polymer P, and an aqueous medium, may be obtained by mixing abrasive grains and the polymer composition of the present embodiment, and may be obtained by mixing the polymer composition of the present embodiment and an abrasive grain-containing liquid containing abrasive grains and an aqueous medium (for example, may be obtained by mixing the polymer composition and the abrasive grain-containing liquid of the polishing liquid set of the present embodiment). That is, a method for producing a polishing liquid of the present embodiment may include, as a step of obtaining a polishing liquid, a step of mixing abrasive grains, polymer P, and an aqueous medium, may include a step of mixing abrasive grains and the polymer composition of the present embodiment, and may include a step of mixing the polymer composition of the present embodiment and an abrasive grain-containing liquid containing abrasive grains and an aqueous medium (for example, a step of mixing the polymer composition and the abrasive grain-containing liquid of the polishing liquid set of the present embodiment).

As the abrasive grains, polymer P, and aqueous medium of the polishing liquid, the abrasive grains, polymer P, and aqueous medium described above for the polymer composition can be used. For example, from the viewpoint of easily obtaining a desired polishing rate of an insulating material (such as silicon oxide), the abrasive grains may contain at least one selected from the group consisting of cerium oxides, silicon oxides (for example, silica), aluminum oxides (for example, alumina), zirconium oxides (for example, zirconia), and yttrium oxides (for example, yttria), and may contain a cerium oxide. Each component of the polishing liquid may be the same as or different from each component of the polymer composition and the abrasive grain-containing liquid.

In the polishing liquid of the present embodiment, polymer P may be used singly, or two or more kinds thereof may be used in combination. For example, as two or more kinds of polymer P, polymers P having different contents of structural units (the first structural unit, the second structural unit, etc.) may be used, and polymers P having different types of structural units (the first structural unit, the second structural unit, etc.) may be used.

The polishing liquid of the present embodiment may contain the above-described components other than abrasive grains, polymer P, and an aqueous medium (water-soluble polymers, pH adjusters, buffers, defoamers, etc.).

A median diameter (D50) of the abrasive grains in the polishing liquid of the present embodiment may be within the following range. The median diameter of the abrasive grains may be 1 nm or more, 5 nm or more, 10 nm or more, 20 nm or more, 30 nm or more, 40 nm or more, 50 nm or more, 60 nm or more, 65 nm or more, 70 nm or more, 75 nm or more, or 80 nm or more, from the viewpoint of easily improving a polishing rate of an insulating material (such as silicon oxide). The median diameter of the abrasive grains may be 1000 nm or less, 500 nm or less, 300 nm or less, 200 nm or less, 150 nm or less, 120 nm or less, 100 nm or less, 90 nm or less, or 80 nm or less, from the viewpoint of easily suppressing scratching on a polished surface. From these viewpoints, the median diameter of the abrasive grains may be 1 to 1000 nm, 10 to 1000 nm, 10 to 500 nm, 30 to 300 nm, 30 to 200 nm, 50 to 150 nm, or 65 to 100 nm.

A content of the abrasive grains may be within the following range based on a total mass of the polishing liquid. The content of the abrasive grains may be 0.01 mass% or more, 0.05 mass% or more, 0.1 mass% or more, 0.15 mass% or more, 0.2 mass% or more, 0.25 mass% or more, 0.3 mass% or more, 0.35 mass% or more, 0.4 mass% or more, 0.45 mass% or more, or 0.5 mass% or more, from the viewpoint of easily improving a polishing rate of an insulating material (such as silicon oxide). The content of the abrasive grains may be 20 mass% or less, 15 mass% or less, 10 mass% or less, 5 mass% or less, 3 mass% or less, 2 mass% or less, 1 mass% or less, 0.8 mass% or less, 0.6 mass% or less, or 0.5 mass% or less. From these viewpoints, the content of the abrasive grains may be 0.01 to 20 mass%, 0.05 to 10 mass%, or 0.1 to 1 mass%.

A content of polymer P may be within the following range based on a total mass of the polishing liquid from the viewpoint of easily suppressing excessive dishing or the viewpoint of easily suppressing excessive polishing of a stopper. The content of polymer P may be 0.01 mass% or more, 0.03 mass% or more, 0.05 mass% or more, 0.08 mass% or more, 0.1 mass% or more, 0.12 mass% or more, 0.14 mass% or more, or 0.15 mass% or more. The content of polymer P may be 10 mass% or less, 8 mass% or less, 5 mass% or less, 3 mass% or less, 2 mass% or less, 1 mass% or less, 0.8 mass% or less, 0.5 mass% or less, 0.3 mass% or less, 0.2 mass% or less, or 0.15 mass% or less. From these viewpoints, the content of polymer P may be 0.01 to 10 mass%, 0.05 to 1 mass%, or 0.1 to 0.5 mass%.

A content of polymer P may be within the following range with respect to 100 parts by mass of the abrasive grains from the viewpoint of easily suppressing excessive dishing or the viewpoint of easily suppressing excessive polishing of a stopper. The content of polymer P may be 1 part by mass or more, 5 parts by mass or more, 6 parts by mass or more, more than 6 parts by mass, 10 parts by mass or more, 15 parts by mass or more, 20 parts by mass or more, 25 parts by mass or more, or 30 parts by mass or more. The content of polymer P may be 100 parts by mass or less, 80 parts by mass or less, 60 parts by mass or less, 55 parts by mass or less, 50 parts by mass or less, 45 parts by mass or less, 40 parts by mass or less, 35 parts by mass or less, or 30 parts by mass or less. From these viewpoints, the content of polymer P may be 1 to 100 parts by mass, 1 to 60 parts by mass, or 10 to 50 parts by mass.

A pH of the polishing liquid of the present embodiment may be within the following range from the viewpoint of easily suppressing excessive dishing or the viewpoint of easily suppressing excessive polishing of a stopper. The pH of the polishing liquid may be 3.0 or more, 3.5 or more, 4.0 or more, 4.5 or more, 5.0 or more, 5.4 or more, or 5.5 or more. The pH of the polishing liquid may be 7.0 or less, less than 7.0, 6.5 or less, 6.0 or less, or 5.5 or less. From these viewpoints, the pH of the polishing liquid may be 3.0 to 7.0, 4.0 to 6.5, or 5.0 to 6.0.

<Polishing Method>

A polishing method of the present embodiment includes a polishing step of polishing a surface to be polished using the polishing liquid of the present embodiment. The polishing liquid used in the polishing step may be obtained by mixing abrasive grains and polymer P, may be obtained by mixing abrasive grains and the polymer composition of the present embodiment, and may be obtained by mixing the polymer composition of the present embodiment and an abrasive grain-containing liquid containing abrasive grains and an aqueous medium (for example, may be obtained by mixing the polymer composition and the abrasive grain-containing liquid of the polishing liquid set of the present embodiment). The polishing method of the present embodiment is, for example, a method of polishing a base substrate having a surface to be polished.

The surface to be polished may contain an insulating material and may contain silicon oxide. The surface to be polished may contain an insulating material and a stopper material (silicon nitride, polysilicon, etc.) and for example, may contain silicon oxide and silicon nitride. The polishing method of the present embodiment may be a method of polishing a base substrate having a surface to be polished containing an insulating material (such as silicon oxide) and a stopper material (silicon nitride, polysilicon, etc.). The base substrate may have, for example, an insulating member containing an insulating material and a stopper containing a stopper material.

The polishing method of the present embodiment may be a polishing method of a surface to be polished containing an insulating material (such as silicon oxide) and a stopper material (silicon nitride, polysilicon, etc.), wherein it may include a polishing step of selectively polishing the insulating material with respect to the stopper material using the polishing liquid of the present embodiment, and it may include a polishing step of selectively polishing silicon oxide with respect to silicon nitride using the polishing liquid of the present embodiment. The term "selectively polishing material A with respect to material B" means that a polishing rate of material A is higher than a polishing rate of material B under the same polishing conditions. In a case where silicon oxide is selectively polished with respect to silicon nitride, a polishing selectivity ratio of silicon oxide with respect to silicon nitride may be 10 or more, 20 or more, 30 or more, or 35 or more.

Examples of the base substrate which is a target to be polished include a base substrate having a member to be polished formed on a substrate used for manufacturing semiconductor components (for example, a semiconductor substrate on which an STI pattern, a gate pattern, a wiring pattern, or the like is formed). Examples of a material to be polished constituting the member to be polished include insulating materials (except for stopper materials) such as silicon oxide and the like; and stopper materials such as silicon nitride and polysilicon. The material to be polished may be a single material and may be a plurality of materials. When a plurality of materials are exposed on the surface to be polished, they can be regarded as materials to be polished. The member to be polished may be film-like (a film to be polished). The insulating member containing an insulating material may be film-like (an insulating film: a silicon oxide film and the like). The stopper containing a stopper material may be film-like (a stopper film: a silicon nitride film, a polysilicon film, and the like).

By using the polishing liquid of the present embodiment, a member to be polished (for example, an insulating film such as a silicon oxide film) formed on a substrate can be polished to remove an unnecessary portion, thereby eliminating protrusions and recesses on the surface of the member to be polished and obtaining a smooth surface over the entire polished surface.

In the polishing method of the present embodiment, it is possible to polish an insulating member of a base substrate (for example, a base substrate having an insulating member, a stopper disposed in a lower layer of the insulating member, and a semiconductor substrate disposed under the stopper), wherein the base substrate has: a substrate with a pattern of protrusions and recesses; a stopper disposed on protrusions of the substrate; and the insulating member (for example, a silicon oxide film containing silicon oxide at least on its surface) disposed on the substrate and the stopper so as to fill recesses of the pattern of protrusions and recesses. In such a base substrate, by stopping polishing when the stopper is exposed, it is possible to prevent the insulating member from being excessively polished, and therefore it is possible to improve the flatness of the insulating member after polishing. A stopper material constituting the stopper is a material having a lower polishing rate than an insulating material, and may be silicon nitride, polysilicon, and the like.

The polishing liquid and the polishing method of the present embodiment can also be used for polishing a pre-metal insulating film. Examples of a material constituting the pre-metal insulating film include silicon oxide, phospho-silicate glass, boro-phospho-silicate glass, silicon oxyfluoride, and fluorinated amorphous carbon.

The polishing liquid and the polishing method of the present embodiment can also be applied to materials other than insulating materials such as silicon oxide. Examples of such materials include high dielectric constant materials such as Hf-based, Ti-based, and Ta-based oxides; semiconductor materials such as silicon, amorphous silicon, SiC, SiGe, Ge, GaN, GaP, GaAs, and organic semiconductors; phase change materials such as GeSbTe; inorganic conductive materials such as ITO; and polymer resin materials such as polyimide, polybenzoxazole, acrylic, epoxy, and phenolic resins.

The polishing liquid and the polishing method of the present embodiment can be applied not only to film-like polishing targets but also to various substrates made of glass, silicon, SiC, SiGe, Ge, GaN, GaP, GaAs, sapphire, plastic, and the like.

The polishing liquid and the polishing method of the present embodiment can be used not only in the manufacture of semiconductor components but also in the manufacture of image display devices such as TFT and organic EL; optical components such as photomasks, lenses, prisms, optical fibers, and single-crystal scintillators; optical elements such as optical switching elements and optical waveguides; light emitting elements such as solid-state lasers and blue laser LEDs; and magnetic storage devices such as magnetic disks and magnetic heads.

<Method for manufacturing component and the like>

A method for manufacturing a component of the present embodiment includes a component producing step of obtaining a component by using a polished member polished by the polishing method of the present embodiment. The component of the present embodiment is a component obtained by the method for manufacturing a component of the present embodiment. The component of the present embodiment is not particularly limited, and may be an electronic component (for example, a semiconductor component such as a semiconductor package), may be a wafer (for example, a semiconductor wafer), and may be a chip (for example, a semiconductor chip). As an embodiment of the method for manufacturing a component of the present embodiment, in a method for manufacturing an electronic component of the present embodiment, an electronic component is obtained by using a polished member polished by the polishing method of the present embodiment. As an embodiment of the method for manufacturing a component of the present embodiment, in a method for manufacturing a semiconductor component of the present embodiment, a semiconductor component (for example, a semiconductor package) is obtained by using a polished member polished by the polishing method of the present embodiment. The method for manufacturing a component of the present embodiment may include a polishing step of polishing a member to be polished by the polishing method of the present embodiment before the component producing step.

The method for manufacturing a component of the present embodiment may include, as an embodiment of the component producing step, an individually dividing step of dividing a polished member polished by the polishing method of the present embodiment. The individually dividing step may be, for example, a step of dicing a wafer (for example, a semiconductor wafer) polished by the polishing method of the present embodiment to obtain chips (for example, semiconductor chips). As an embodiment of the method for manufacturing a component of the present embodiment, the method for manufacturing an electronic component of the present embodiment may include a step of obtaining an electronic component (for example, a semiconductor component) by individually dividing a polished member polished by the polishing method of the present embodiment. As an embodiment of the method for manufacturing a component of the present embodiment, the method for manufacturing a semiconductor component of the present embodiment may include a step of obtaining a semiconductor component (for example, a semiconductor package) by individually dividing a polished member polished by the polishing method of the present embodiment.

The method for manufacturing a component of the present embodiment may include, as an embodiment of the component producing step, a connecting step of connecting (for example, electrically connecting) a polished member polished by the polishing method of the present embodiment to another body to be connected. The body to be connected that is connected to the polished member polished by the polishing method of the present embodiment is not particularly limited, and may be a polished member polished by the polishing method of the present embodiment, and may be a body to be connected different from the polished member polished by the polishing method of the present embodiment. In the connecting step, the polished member and the body to be connected may be directly connected to each other (connected in a state where the polished member and the body to be connected are in contact with each other), and the polished member and the body to be connected may be connected via another member (such as a conductive member). The connecting step can be performed before the individually dividing step, after the individually dividing step, or before and after the individually dividing step.

The connecting step may be a step of connecting a polished surface of a polished member polished by the polishing method of the present embodiment to a body to be connected, and may be a step of connecting a connection surface of a polished member polished by the polishing method of the present embodiment to a connection surface of a body to be connected. The connection surface of the polished member may be a polished surface polished by the polishing method of the present embodiment. A connection body having the polished member and the connected body can be obtained by the connecting step. In the connecting step, in a case where the connection surface of the polished member has a metal portion, the body to be connected may be connected to the metal portion. In the connecting step, in a case where the connection surface of the polished member has a metal portion and the connection surface of the body to be connected has a metal portion, the metal portions may be connected to each other. The metal portion may contain copper.

A device (for example, an electronic device such as a semiconductor device) of the present embodiment has at least one selected from the group consisting of the polished member polished by the polishing method of the present embodiment and the component of the present embodiment.

**Examples**

Hereinafter, the present disclosure will be described specifically based on Examples, but the present disclosure is not limited to the Examples.

<Preparation of Polymer Composition>

In each of Examples and Comparative Examples, a polymer composition having a polymer content of 3.0 mass% and a pH (25°C) of 5.2 was obtained by mixing the polymer of Table 1, a pH adjuster, and ion-exchanged water. In all of Examples and Comparative Examples, a 10 mass% aqueous acetic acid solution was used as the pH adjuster. The pH of the polymer composition was measured in accordance with the measurement method described in the definition of pH above. Types of structural units contained in the polymer in each of Examples and Comparative Examples are as shown in Table 1. In Table 1, "St" represents styrene, "MAa" represents methacrylic acid, and "Aa" represents acrylic acid. The polymer in Table 1 has each structural unit at a monomer ratio shown in Table 1.

<Weight-Average Molecular Weight of Polymer>

Measurement of gel permeation chromatography (GPC) was performed under the conditions below, and the weight-average molecular weight (Mw) of the polymer described above was measured as a pullulan-equivalent value. The measurement results are shown in Table 1.

Measuring apparatus (detector): Shodex GPC-101, manufactured by Showa Denko K.K.
Column: Shodex SB-807, 806M, 803, manufactured by Showa Denko K.K.
Eluent: 0.05 M aqueous disodium hydrogen phosphate solution
Measurement temperature: 40°C
Flow rate: 0.8 mL/min
Measurement time: 60 minutes
Sample: A sample prepared by adjusting the polymer content of the polymer composition with a solution having the same composition as that of the eluent so that the polymer content becomes 0.1 mass%, and filtering through a 0.45 $\mu$m membrane filter
Injection amount: 100 $\mu$L
Standard substance: Shodex STANDARD P-82, manufactured by Showa Denko K.K.

<Converted Total Amount of Carboxyl Groups and Carboxylate Groups in Polymer>

A converted total amount C [mol/g] of carboxyl groups and carboxylate groups in the polymer described above was calculated from the equation below. The results are shown in Table 1.

$$C = \Sigma\{N_i \times (R_i/100)\}/\Sigma\{M_i \times (R_i/100)\}$$

$M_i$: molecular weight [g/mol] of each monomer used to obtain the polymer (provided that, in a case where a carboxyl group forms a salt (for example, in a case where a carboxylate is used as a monomer, in a case where a salt is formed by ion exchange or the like after polymerization of a carboxylic acid, and the like), a molecular weight in which these structures are replaced with a carboxyl group (COOH))
$N_i$: valence of carboxyl groups and carboxylate groups in each monomer (for example, $N_i = 0$ for styrene)
$R_i$: Rate [mol%] of each monomer in a total amount of monomers used to obtain the polymer

<Storage Stability of Polymer Composition>

(Visual Observation of Presence or Absence of Precipitates)

First, after 45 g of the polymer composition described above was sealed in a 50 mL centrifuge tube, this centrifuge tube was allowed to stand at 60°C for 7 days (168 hours). Thereafter, the centrifuge tube was cooled to 25°C and centrifuged for 40 minutes at a centrifugal acceleration of 9700 G (9700 times gravitational acceleration) using a centrifuge (high-speed large-capacity refrigerated centrifuge 7000, manufactured by KUBOTA Corporation). Thereafter, presence or absence of precipitates generated in the centrifuge tube was visually observed, and evaluated according to the criteria below. From the centrifugation to the observation and during the observation, the polymer composition was kept at 25°C. The results are shown in Table 1.

A: Neither precipitates nor turbidity are observed.
B: Slight precipitates are observed but they are redissolved by shaking.
C: More precipitates than in B are observed but they are redissolved by shaking.
D: Precipitates are observed and are not redissolved even by shaking.

(Measurement of Transmittance)

The transmittance of the polymer composition (supernatant liquid) after the centrifugation described above was measured. Specifically, the transmittance of light having a wavelength of 700 nm was measured using a spectrophotometer (product name: UV-1900, manufactured by Shimadzu Corporation) and a quartz cell having an optical path length of 10 mm. From the centrifugation to the measurement and during the measurement, the polymer composition was kept at 25°C. The results are shown in Table 1.

<Preparation of Polishing Liquid>

In Examples 1 to 5 and Comparative Examples 1 to 3, 100 parts by mass of a polishing liquid (CMP polishing liquid) having a pH of 5.5 was prepared by mixing 0.5 parts by mass of abrasive grains (ceria particles), 0.15 parts by mass of the polymer in Table 1, 0.06 parts by mass of acetic acid, 0.003 parts by mass of a defoamer (silicone mixture, product name: TSA780, manufactured by Momentive Performance Materials Japan LLC), and ion-exchanged water. The polymer in Table 1 was supplied using the polymer composition described above. The pH of the polishing liquid was measured in accordance with the measurement method described in the definition of pH above. As a result of measuring a median diameter (D50) of the abrasive grains in accordance with the measurement method described in the definition of the median diameter above, the median diameter in Examples 1 to 5 and Comparative Examples 1 to 3 was 80 nm.

<Polishing of Substrate to Be Polished>

A substrate to be polished was polished using the polishing liquids of Examples 1 to 5 and Comparative Examples 1 to 3 under the polishing conditions below.

{Polishing Conditions}

    Polishing apparatus: Reflexion LK (manufactured by APPLIED MATERIALS)
    Flow rate of polishing liquid: 250 mL/min
    Substrate to be polished: pattern wafer described below
    Polishing pad: foamed polyurethane resin having closed cells (model IC1010, manufactured by Dow Chemical Japan Limited)
    Polishing pressure: 3.0 psi (20.6 kPa)
    Rotation speed of substrate and polishing platen: substrate/polishing platen = 93/87 rpm
    Polishing time: 15 seconds after exposure of stopper
    Drying of wafer: drying was performed with a spin dryer after polishing.

{Pattern Wafer}

The pattern wafer having a simulated pattern was a wafer obtained by forming a silicon nitride film (SiN film) as a stopper on a silicon substrate, forming trenches in an exposure and development step, and forming a silicon oxide film ($SiO_2$ film) as an insulating film on the silicon substrate and the stopper so as to fill the stopper and the trenches. The silicon oxide film was formed by an HDP (High Density Plasma) method.

The pattern wafer described above had "a portion in which lines (L) as protrusions / spaces (S) as recesses had a pitch of 100 $\mu$m and a pattern density of protrusions was 50%" (portion of L/S = 50/50 $\mu$m) and "a portion in which L/S had a pitch of 100 $\mu$m and a pattern density of protrusions was 20%" (portion of L/S = 20/80 $\mu$m).

L/S is a simulated pattern in which an Active portion masked with a silicon nitride film as a protrusion and a Trench portion in which a groove as a recess is formed are alternately arranged. For example, "L/S had a pitch of 100 $\mu$m" means that a sum of widths of an Active portion (line portion) and a Trench portion (space portion) is 100 $\mu$m. For example, "L/S had a pitch of 100 $\mu$m and a pattern density of protrusions was 50%" means a pattern in which protrusions having a width of 50 $\mu$m and recesses having a width of 50 $\mu$m are alternately arranged.

In the pattern wafer, a film thickness of the silicon oxide film was 420 nm on both the silicon substrate at recesses and the silicon nitride film at protrusions. Specifically, a film thickness of the silicon nitride film on the silicon substrate was 120 nm, a film thickness of the silicon oxide film at the protrusions was 420 nm, a film thickness of the silicon oxide film at the recesses was 420 nm, and a recess depth of the silicon oxide film was 300 nm (trench depth of 180 nm + film thickness of the silicon nitride film of 120 nm).

<Evaluation of Polishing Characteristics>

After the substrate to be polished (pattern wafer) was polished under the polishing conditions described above to expose the stopper and then further polished for 15 seconds (over-polishing), the stopper polishing amount (SiN loss) and a remaining step amount (Dishing) at the "portion of L/S = 50/50 $\mu$m" and the "portion of L/S = 20/80 $\mu$m" were calculated according to the procedure below.

(Stopper Polishing Amount)

The stopper polishing amount (SiN loss) was determined by a difference between an initial film thickness of the stopper at the protrusions and a remaining film thickness of the stopper after polishing at the protrusions according to the equation below. The film thicknesses of the stopper before and after polishing were determined using an optical interference film thickness measuring apparatus (product name: Nova i500, manufactured by Nova). The results are shown in Table 1.

(Stopper polishing amount [nm]) = (initial film thickness of stopper at protrusions [nm]) - (remaining film thickness of stopper after polishing at protrusions [nm])

(Remaining Step Amount)

The "portion of L/S = 50/50 μm" and the "portion of L/S = 20/80 μm" in the polished substrate were scanned with an automatic atomic force step profiler (product name: InSight CAP, manufactured by Bruker) to measure a height difference between protrusions and recesses, thereby obtaining a remaining step amount (Dishing). The results are shown in Table 1.

[Table 1]

| | | | Example 1 | Example 2 | Example 3 | Example 4 | Example 5 | Comparative Example 1 | Comparative Example 2 | Comparative Example 3 | Comparative Example 4 |
|---|---|---|---|---|---|---|---|---|---|---|---|
| Polymer | Monomer species | | St/MAa | St/MAa | St/MAa | St/MAa | St/MAa/Aa | St/Aa | St/Aa | MAa | St/MAa |
| | Monomer ratio [mol%] | St | 14 | 17 | 20 | 30 | 30 | 20 | 30 | 0 | 40 |
| | | MAa | 86 | 83 | 80 | 70 | 10 | 0 | 0 | 100 | 60 |
| | | Aa | 0 | 0 | 0 | 0 | 60 | 80 | 70 | 0 | 0 |
| | Weight-average molecular weight | | 43000 | 43000 | 42000 | 39000 | 79000 | 62000 | 76000 | 40000 | 40000 |
| | Total amount of carboxyl groups and carboxylate groups [mol/g] | | 9.7E-03 | 9.3E-03 | 8.9E-03 | 7.7E-03 | 8.4E-03 | 1.0E-02 | 8.6E-03 | 1.2E-02 | 6.4E-03 |
| Storage stability of polymer composition | Visual observation | | A | A | A | A | B | C | D | A | D |
| | Transmittance [%] | | 97 | 98 | 97 | 96 | 94 | 94 | 87 | 98 | 71 |
| Polishing characteristics | SiN loss [nm] | L/S = 50/50 | 0.3 | 0 | 0 | 0 | 0.1 | 1.1 | 0.1 | 2.5 | - |
| | | L/S = 20/80 | 1.7 | 1.1 | 1.2 | 1.8 | 1.5 | 4.3 | 1.9 | 10 | - |
| | Dishing [nm] | L/S = 50/50 | 4.9 | 2.1 | 4.3 | 10 | 16 | 32 | 18 | 15 | - |
| | | L/S = 20/80 | 12 | 7.1 | 17 | 26 | 38 | 77 | 43 | 66 | - |

**Claims**

1. A polymer for a polishing liquid, comprising:

   a first structural unit derived from at least one styrenic compound selected from the group consisting of styrene and styrene derivatives and a second structural unit derived from at least one methacrylic acid compound selected from the group consisting of methacrylic acid and its salts,
   wherein a content of the first structural unit is more than 0 mol% and 38 mol% or less.

2. The polymer according to claim 1, wherein the first structural unit includes a structural unit derived from styrene.

3. The polymer according to claim 1 or 2, wherein a content of the second structural unit is 60 to 90 mol%.

4. The polymer according to any one of claims 1 to 3, wherein a converted total amount of carboxyl groups and carboxylate groups is $6.7 \times 10^{-3}$ mol/g or more, and the converted total amount is calculated by replacing carboxylate groups in the polymer with carboxyl groups.

5. The polymer according to any one of claims 1 to 4, wherein a weight-average molecular weight is 3000 to 500000.

6. A polymer composition comprising the polymer according to any one of claims 1 to 5 and an aqueous medium.

7. A polishing liquid set comprising the polymer composition according to claim 6 and a liquid containing abrasive grains and an aqueous medium.

8. The polishing liquid set according to claim 7, wherein the abrasive grains contain at least one selected from the group consisting of cerium oxides, silicon oxides, aluminum oxides, zirconium oxides, and yttrium oxides.

9. A polishing liquid comprising abrasive grains, the polymer according to any one of claims 1 to 5, and an aqueous medium.

10. The polishing liquid according to claim 9, wherein the abrasive grains contain at least one selected from the group consisting of cerium oxides, silicon oxides, aluminum oxides, zirconium oxides, and yttrium oxides.

11. A method for producing a polishing liquid, comprising a step of mixing the polymer composition according to claim 6 and a liquid containing abrasive grains and an aqueous medium.

12. A polishing method comprising a step of polishing a surface to be polished using the polishing liquid according to claim 9.

## INTERNATIONAL SEARCH REPORT

International application No.

**PCT/JP2024/032407**

### A. CLASSIFICATION OF SUBJECT MATTER

**C08F 220/06**(2006.01)i; **B24B 37/00**(2012.01)i; **C08L 33/02**(2006.01)i; **C09K 3/14**(2006.01)i; **H01L 21/304**(2006.01)i
FI: C08F220/06; B24B37/00 H; C08L33/02; C09K3/14 550; C09K3/14 550D; C09K3/14 550Z; H01L21/304 622D

According to International Patent Classification (IPC) or to both national classification and IPC

### B. FIELDS SEARCHED

Minimum documentation searched (classification system followed by classification symbols)

C08F220/06; B24B37/00; C08L33/02; C09K3/14; H01L21/304

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

CAplus/REGISTRY (STN)

### C. DOCUMENTS CONSIDERED TO BE RELEVANT

| Category* | Citation of document, with indication, where appropriate, of the relevant passages | Relevant to claim No. |
|---|---|---|
| X | JP 2000-108495 A (FUJI XEROX CO., LTD.) 18 April 2000 (2000-04-18) claims, paragraphs [0063], [0079] | 1-6 |
| X | JP 11-100772 A (SANYO CHEMICAL INDUSTRIES, LTD.) 13 April 1999 (1999-04-13) claims, paragraph [0056] | 1-2, 4-6 |
| X | JP 2020-026490 A (TOSOH CORP.) 20 February 2020 (2020-02-20) claims, paragraphs [0117]-[0120] | 1, 3-6 |
| X | JP 2019-059915 A (FUJIMI INC.) 18 April 2019 (2019-04-18) claims, example 32, paragraphs [0100]-[0103], [0159] | 1-6, 9-10, 12 |
| Y | claims, example 32, paragraphs [0031], [0100]-[0103], [0159] | 7-8, 11 |
| Y | JP 2017-110177 A (HITACHI CHEMICAL COMPANY, LTD.) 22 June 2017 (2017-06-22) paragraphs [0016], [0064]-[0067] | 7-8, 11 |

☑ Further documents are listed in the continuation of Box C.      ☑ See patent family annex.

| | | |
|---|---|---|
| * | Special categories of cited documents: | "T" later document published after the international filing date or priority date and not in conflict with the application but cited to understand the principle or theory underlying the invention |
| "A" | document defining the general state of the art which is not considered to be of particular relevance | |
| "D" | document cited by the applicant in the international application | "X" document of particular relevance; the claimed invention cannot be considered novel or cannot be considered to involve an inventive step when the document is taken alone |
| "E" | earlier application or patent but published on or after the international filing date | |
| "L" | document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" | document referring to an oral disclosure, use, exhibition or other means | |
| "P" | document published prior to the international filing date but later than the priority date claimed | "&" document member of the same patent family |

| Date of the actual completion of the international search | Date of mailing of the international search report |
|---|---|
| **08 November 2024** | **26 November 2024** |

| Name and mailing address of the ISA/JP | Authorized officer |
|---|---|
| **Japan Patent Office (ISA/JP)** 3-4-3 Kasumigaseki, Chiyoda-ku, Tokyo 100-8915 Japan | |
| | Telephone No. |

Form PCT/ISA/210 (second sheet) (July 2022)

**INTERNATIONAL SEARCH REPORT**

International application No.

**PCT/JP2024/032407**

| C. | DOCUMENTS CONSIDERED TO BE RELEVANT | |
|---|---|---|
| Category* | Citation of document, with indication, where appropriate, of the relevant passages | Relevant to claim No. |
| Y | JP 2022-040139 A (SHOWA DENKO MATERIALS CO., LTD.) 10 March 2022 (2022-03-10)<br>paragraphs [0068]-[0070] | 7-8, 11 |

Form PCT/ISA/210 (second sheet) (July 2022)

## INTERNATIONAL SEARCH REPORT
### Information on patent family members

International application No.

**PCT/JP2024/032407**

| Patent document cited in search report | | | Publication date (day/month/year) | Patent family member(s) | | | Publication date (day/month/year) |
|---|---|---|---|---|---|---|---|
| JP | 2000-108495 | A | 18 April 2000 | (Family: none) | | | |
| JP | 11-100772 | A | 13 April 1999 | (Family: none) | | | |
| JP | 2020-026490 | A | 20 February 2020 | (Family: none) | | | |
| JP | 2019-059915 | A | 18 April 2019 | US<br>claims, example 32,<br>paragraphs [0037], [0108]-<br>[0112], [0209]<br>KR<br>TW<br>TW | 2019/0093051<br><br><br><br>10-2019-0035490<br>201915158<br>202244263 | A1<br><br><br><br>A<br>A<br>A | |
| JP | 2017-110177 | A | 22 June 2017 | JP | 2017-110219 | A | |
| JP | 2022-040139 | A | 10 March 2022 | US<br>paragraphs [0092]-[0095]<br>WO<br>TW<br>KR<br>CN<br>SG<br>KR<br>TW<br>KR<br>CN | 2021/0189176<br><br>2019/064524<br>201920535<br>10-2020-0039773<br>111149193<br>11202002314W<br>10-2022-0065096<br>202321392<br>10-2023-0134157<br>117050726 | A1<br><br>A1<br>A<br>A<br>A<br>A<br>A<br>A<br>A<br>A | |

Form PCT/ISA/210 (patent family annex) (July 2022)

**EP 4 772 550 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2015170436 A
- JP 2011103498 A
- WO 2007055278 A